# EUROPÄISCHE PATENTSCHRIFT

(11) **EP 1 078 401 B1**
(45) Veröffentlichungstag und Bekanntmachung des Hinweises auf die Patenterteilung: **04.08.2010**
(21) Anmeldenummer: 99932653.1
(22) Anmeldetag: 07.05.1999
(51) Int. Cl.: H01L 27/02, H02H 5/04

(54) **VERFAHREN ZUR STEUERUNG EINES POWER-MOS-TRANSISTORS**
METHOD OF CONTROLLING A POWER MOSFET
METHODE DE COMMANDE D'UN TRANSISTOR DE PUISSANCE A EFFET DE CHAMP

(30) Priorität: 15.05.1998 DE 19821834
(43) Veröffentlichungstag der Anmeldung: 28.02.2001
(73) Patentinhaber: Robert Bosch GmbH, 70442 Stuttgart (DE)
(72) Erfinder: HERSEL, Walter, D-71229 Leonberg (DE); BREITLING, Wolfram, D-74343 Sachensheim (DE); WEIBLE, Reinhold, D-70437 Stuttgart (DE); FALLIANO, Rolf, D-73635 Rudersberg-Steinenberg (DE)
(74) Vertreter: Behrens, Ralf Holger
(86) Internationale Anmeldenummer: PCT/DE1999/001378
(87) Internationale Veröffentlichungsnummer: WO 1999/060628

(56) Entgegenhaltungen:
- EP-A- 0 414 499
- EP-A- 0 565 807
- WO-A-98/06142
- US-A- 5 304 837
- US-A- 5 457 419
- US-A- 5 726 481
- PATENT ABSTRACTS OF JAPAN vol. 13, no. 246 (E-769), 8. Juni 1989 (1989-06-08) -& JP 01 047077 A (TDK CORP), 21. Februar 1989 (1989-02-21)

## Beschreibung

### Stand der Technik

Die Erfindung betrifft ein Verfahren zur Ansteuerung eines Power-MOS-Transistors mit einem in einem Transistorgehäuse untergebrachten PMT-Chip, bei dem die Temperatur der Transistorsperrschicht überwacht ist.

In der EP 0 414 499 A2 ist ein MOS-Transistor mit Temperatur-Schutzschaltung beschrieben, die ein Substrat-Temperatursensorelement in einer Schichtstruktur des MOS-Transistors aufweist. Beim Erreichen einer oberen Temperaturgrenze wird der MOS-Transistor abgeschaltet und bleibt in diesem Zustand bis eine Temperatursensoreinheit abgekühlt ist.

Die US 5,457,419 zeigt einen MOS-Transistor mit einer zweistufig ausgelegten Schutzschaltung, bei der bei Erreichen eines vorgegebenen niedrigeren Temperaturniveaus der Strom über den Drain-Source-Pfad des MOS-Transistors verringert wird, woraus sich ein verlangsamter Temperaturanstieg ergibt, und bei Erreichen eines höheren Temperaturniveaus der MOS-Transistor abgeschaltet wird.

Bei dem Einsatz eines Power-MOS-Transistors tritt das Problem auf, dass abhängig von der im PMT-Chip entstehenden Verlustleistung eine Temperaturüberhöhung der Transistorsperrschicht gegenüber der Umgebungstemperatur auftritt. Da die maximal zulässige Sperrschichttemperatur bei Halbleitern begrenzt ist, muss in jedem Einsatzfall sichergestellt sein, dass diese maximal zulässige Sperrschichttemperatur nicht überschritten wird.

Es sind verschiedene Lösungen bekannt, die von der Einsatzart des Power-MOS-Transistors abhängig sind. So werden z. B. bei Gebläsereglern meistens mehrere Power-MOS-Transistoren parallelgeschaltet und zur Wärmeabfuhr auf einem Kühlkörper befestigt. Die aufgrund der Verlustleistung im PMT-Chip entstehende Wärme wird von der Transistorsperrschicht auf den Kühlkörper geleitet und an die Umgebung abgegeben. Aus der Kühlkörpertemperatur und der momentanen Verlustleistung wird die Sperrschichttemperatur ermittelt und mittels einer zusätzlichen Schutzschaltung die maximale Verlustleistung begrenzt.

Diese Lösung hat verschiedene Nachteile. So tritt abhängig von der im PMT-Chip entstehenden Verlustleistung zwischen der Messstelle und der Transistorsperrschicht eine mehr oder weniger große Temperaturdifferenz auf. Aufgrund der Masse des Kühlkörpers tritt ein Zeitversatz zwischen der Sperrschichttemperatur und der Messstelle auf.

Bei einer fehlerhaften Montage, z. B. Schmutz zwischen der Transistorkühlfahne und dem Kühlkörper, des Power-MOS-Transistors auf dem Kühlkörper ist die ermittelte Sperrschichttemperatur geringer als die reale Sperrschichttemperatur, so dass die Gefahr der Zerstörung des Power-MOS-Transistors besteht. Um dies zu verhindern, müssen der PMT-Chip selbst und die Schutzschaltung überdimensioniert werden.

Es ist auch schon versucht worden, die Sperrschichttemperatur direkt auf der Transistorsperrschicht zu messen und direkt auf diese gemessene Temperatur zu reagieren. Dabei ist in der Schutzschaltung eine Temperaturschwelle vorgegeben, bei der der Drainstrom des Power-MOS-Transistors abgeschaltet wird. Dabei kann die Abschaltung des Drainstromes sofort (OMNIFET) oder zeitlich verzögert (HITFET) erfolgen, um eine Überlastung und Zerstörung des Power-MOS-Transistors zu verhindern.

Es ist Aufgabe der Erfindung, ein Verfahren zur Ansteuerung eines Power-MOS-Transistors der eingangs erwähnten Art zu schaffen Power-MOS-Transistor, der wobei ohne Überdimensionierung des PMT-Chips und der Schutzschaltung gegen Überlastung und Zerstörung geschützt ist ohne sein Schaltverhalten zu beeinträchtigen.

Diese Aufgabe wird bei dem erfindungsgemäßen Verfahren zur Ansteuerung eines Power-MOS-Transistors mit einem in einem Transistorgehäuse untergebrachten PMT-Chip, dessen Gate-Anschluss über einen widerstand mit einem Gate-Anschluss des Power-MOS-Transistors verbunden ist und bei dem die Temperatur der Transistorsperrschicht überwacht ist, wobei im Transistorgehäuse eine Schutzschaltung vorgesehen ist, die die Temperatur der Transistorsperrschicht mit einem Temperaturmesselement direkt misst und beim Erreichen einer vorgebbaren Grenzsperrschichttemperatur den Drainstrom und damit die Verlustleistung des PMT-Chips verringert, wobei das Temperaturmesselement in den PMT-Chip integriert oder mit der Schutzschaltung als Zusatz-Chip im Transistorgehäuse untergebracht ist, dadurch gelöst, dass die Grenzsperrschichttemperatur als Sollwert über eine an dem Gate-Anschluss des Power-MOS-Transistors angelegte Gate-Spannung vorgegeben ist, dass der der Sperrschichttemperatur entsprechende Messwert mit dem Sollwert verglichen wird und dass über einen Verstärker die Gate-Spannung am Gate-Anschluss des PMT-Chips derart auf eine konstante Sperrschichttemperatur geregelt ist, dass die Schutzschaltung den Drainstrom nicht abschaltet, sondern nur verringert.

Mit dieser Schutzschaltung ergibt sich eine konstante maximal erreichbare Sperrschichttemperatur, die der Grenzsperrschichttemperatur entspricht und die unabhängig von der an dem Power-MOS-Transistor angelegten Gate-Spannung und der Schwellenspannung des PMT-Chips ist. Solange die sich im PMT-Chip einstellende Sperrschalttemperatur kleiner als die Grenzsperrschichttemperatur ist, hat die Schutzschaltung keinerlei Einfluß auf das Schaltverhalten des Power-MOS-Transistors.

Da beim Erreichen der Grenzsperrschichttemperatur der Drainstrom nicht abgeschaltet wird, entfällt bei dem erfindungsgemäßen der Verfahren der Wiedereinschaltvorgang. Der dafür erforderliche externe Aufwand bekannter Schaltungen entfällt daher. Bei Applikationen, bei denen der PMT-Chip versucht, selbsttätig wieder einzuschalten, entstehen Schwingvorgänge, die zu Anlagen-Geräuschen oder bei anderen bestimmungsgemäßen Einsatzfällen zu elektromagnetischen Störungen führen. Dies wird beim erfindungsgemäßen Verfahren ebenfalls vermieden.

Außerdem hat das erfindungsgemäße Verfahren den Vorteil, dass im Fehlerfall die Sperrschichttemperatur auf einen konstanten Wert begrenzt wird. Die Leistung wird nicht abgeschaltet sondern nur zurückgeregelt, was bei bestimmten Applikationen einen Notbetrieb oder bestimmungsgemäßen Betrieb gestattet. Außerdem können bei linearen und/oder getakteten Applikationen mehrere Power-MOS-Transistoren der neuen Art ohne zusätzlichen Schaltungsaufwand direkt parallelgeschaltet werden.

Das interne Temperaturmeßelement kann ein auf Siliziumbasis arbeitendes Temperaturelement sein, das ein der Temperatur der Transistorsperrschicht proportionales Ausgangssignal (Strom, Spannung, Widerstand) abgibt. Es kann ein NTC- oder PTC-Widerstand sein.

Die Erfindung wird anhang des in der Zeichnung dargestellten Ausführungsbeispiels näher erläutert. Es zeigt.

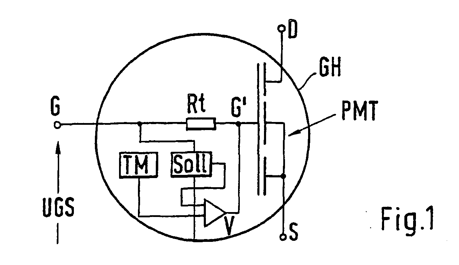

- Fig. 1: einen Power-MOS-Transistor, bei dem der Sollwert von der Gate- Spannung abgeleitet ist.

Bei dem in Fig. 1 dargestellten Power-MOS-Transistor sind am Transistorgehäuse GH drei Anschlüsse G, D und S vorgesehen, wobei die Anschlüsse D und S direkt mit dem Drain-Anschluss und dem source-Anschluss des PMT-Chips in Verbindung stehen. Der Anschluß G führt über einen Widerstand Rt auf den Gate-Anschluß G' des PMT-Chips, wobei die Möglichkeit besteht, die Sperrschicht-Solltemperatur über die Spannung UGS am Gate-Anschluss G des Power-MOS-Transistors vorzugeben. Die Solltemperatur ist eine Funktion der Spannung UGS, d. h. über die Spannung UGS lässt sich eine Grenzsperrschichttemperatur vorgeben. Dies bedeutet, dass bei linearen Applikationen der Ansteuerungsgrad des PMT-Chips mit der Solltemperatur verknüpft ist.

Das interne Temperaturmesselement TM kann ein NTC- oder PTC-Widerstand oder ein auf Siliziumbasis arbeitendes Temperaturelement sein. Zwischen den Anschlüssen wird ein der Temperatur proportionales Signal (z.B. Widerstand, Strom oder Spannung) erhalten.

Power-Mos-Transistoren gemäß der Fig. 1 sind besonders für Applikationen geeignet, bei denen die Grenzsperrschichttemperatur verändert werden muss, z.B. zur Einengung der Sperrschicht-Temperaturdifferenz bei parallelgeschalteten Power-MOS-Transistoren. Die Verlustleistung wird dabei über die Grenzsperrschichttemperatur aufgeteilt. Übernimmt aufgrund der Toleranzen zunächst ein Power-MOS-Transistor die gesamte Verlustleistung und wird die Grenzsperrschichttemperatur erreicht, dann reduziert er seinen Drainstrom. Daraus resultiert eine Abweichung des Istwerts (Spannung zu klein) und die Power-MOS-Transistoren werden weiter aufgesteuert (z.B. externer Spannungsregler erhöht die Spannung UGS). Damit wird ein zweiter Power-MOS-Transistor leitend und übernimmt den Anteil der Verlustleistung, die beim ersten Power-MOS-Transistor zu einer Überschreitung der Grenzsperrschichttemperatur führen würde.

Die mittels des erfindungsgemäßen Verfahrens angesteuerten Power-MOS-Transistoren können mit allen bekannten Schutzschaltungen mit Strombegrenzung, Überspannungsschutz und dergleichen und in praktisch allen Applikationen verwendet werden.

## Patentansprüche

1. Verfahren zur Ansteuerung eines Power-MOS-Transistors, wobei der Power-MOS-Transistor einen in einem Transistorgehäuse (GH) untergebrachten PMT-Chip (PMT) aufweist, dessen Gate-Anschluss (G') über einen Widerstand (Rt) mit einem Gate-Anschluss (G) des Power-MOS-Transistors verbunden ist und bei dem die Temperatur der Transistorsperrschicht überwacht ist, wobei im Transistorgehäuse (GH) eine Schutzschaltung vorgesehen ist, die die Temperatur der Transistorsperrschicht mit einem Temperaturmesselement (TM) direkt misst und beim Erreichen einer vorgebbaren Grenzsperrschichttemperatur den Drainstrom und damit die Verlustleistung des PMT-Chips (PMT) verringert, wobei das Temperaturmesselement (TM) in den PMT-Chip (PMT) integriert oder mit der Schutzschaltung als Zusatz-Chip im Transistorgehäuse (GH) untergebracht ist, **dadurch gekennzeichnet, dass** die Grenzsperrschichttemperatur als Sollwert über eine an dem Gate-Anschluss (G) des Power-MOS-Transistors angelegte Gate-Spannung (UGS) vorgegeben ist, dass der der Sperrschichttemperatur entsprechender Messwert mit dem Sollwert verglichen wird und dass über einen Verstärker (V) die Gate-Spannung (UGS') am Gate-Anschluss (G') des PMT-Chips (PMT) derart auf eine konstante Sperrschichttemperatur geregelt ist, dass die Schutzschaltung den Drainstrom nicht abschaltet, sondern nur verringert.

2. Verfahren nach Anspruch 1 **dadurch gekennzeichnet, dass** als Temperaturmesselement (TM) ein auf Siliziumbasis arbeitendes Temperaturelement verwendet ist, das in Abhängigkeit von der anliegenden Temperatur der Transistorsperrschicht ein proportionales Ausgangssignal, insbesondere Strom, Spannung, Widerstand, abgibt.

3. Verfahren nach Anspruch 1, **dadurch gekennzeichnet, dass** als Temperaturmesselement (TM) ein NTC- oder PTC-Widerstand verwendet ist.

4. Verfahren nach einem der vorhergehenden Ansprüche, **dadurch gekennzeichnet, dass** das Temperaturmesselement (TM) auf dem PMT-Chip (PMT) befestigt ist.

## Claims

1. Method for driving a power MOS transistor, wherein the power MOS transistor has a PMT chip (PMT) which is accommodated in a transistor housing (GH) and the gate terminal (G') of which is connected to a gate terminal (G) of the power MOS transistor via a resistor (Rt) and in which the temperature of the transistor depletion layer is monitored, wherein a protective circuit is provided in the transistor housing (GH), which protective circuit directly measures the temperature of the transistor depletion layer by means of a temperature measuring element (TM) and, in the event of a predeterminable limiting depletion layer temperature being reached, reduces the drain current and thus the power loss of the PMT chip (PMT), wherein the temperature measuring element (TM) is integrated into the PMT chip (PMT) or is accommodated with the protective circuit as an additional chip in the transistor housing (GH), **characterized in that** the limiting depletion layer temperature is predetermined as a desired value by means of a gate voltage (UGS) applied to the gate terminal (G) of the power MOS transistor, **in that** the measured value corresponding to the depletion layer temperature is compared with the desired value, and **in that**, by means of an amplifier (V), the gate voltage (UGS') at the gate terminal (G') of the PMT chip (PMT) is regulated to a constant depletion layer temperature in such a way that the protective circuit does not turn the drain current off, but rather only reduces it.

2. Method according to Claim 1, **characterized in that** the temperature measuring element (TM) used is a temperature element which operates on a silicon basis and which emits, depending on the temperature of the transistor depletion layer that is present, a proportional output signal, in particular current, voltage, resistance.

3. Method according to Claim 1, **characterized in that** an NTC or PTC thermistor is used as the temperature measuring element (TM).

4. Method according to any of the preceding claims, **characterized in that** the temperature measuring element (TM) is fixed on the PMT chip (PMT).

## Revendications

1. Procédé de commande d'un transistor MOS de puissance, le transistor MOS de puissance présentant une puce PMT (PMT) placée dans un boîtier de transistor (GH) et dont la borne de grille (G') est reliée par l'intermédiaire d'une résistance (Rt) à une borne de grille (G) du transistor MOS de puissance, et dans lequel
la température de la couche de blocage du transistor est surveillée,
un circuit de protection qui mesure directement la température de la couche de blocage du transistor à l'aide d'un élément (TM) de mesure de température et qui, lorsque la couche de blocage a atteint une température limite prédéterminée, diminue le courant de drain et donc la puissance de perte de la puce PMT (PMT) est prévu dans le boîtier de transistor (GH), l'élément (TM) de mesure de température étant intégré dans la puce PMT (PMT) ou étant placé comme puce supplémentaire dans le boîtier de transistor (GH) avec le circuit de protection,
**caractérisé en ce que**
la température limite de la couche de blocage est prédéterminée comme valeur de consigne par l'intermédiaire de la tension de grille (UGS) appliquée sur la borne de grille (G) du transistor MOS de puissance,
**en ce que** la valeur de mesure qui correspond à la température de la couche de blocage est comparée à la valeur de consigne et
**en ce que** la tension de grille (UGS') de la borne de grille (G') de la puce PMT (PMT) est régulée par l'intermédiaire d'un amplificateur (V) de manière à maintenir constante la température de la couche de blocage de telle sorte que le circuit de protection ne débranche pas le courant de drain mais le diminue seulement.

2. Procédé selon la revendication 1, **caractérisé en ce qu'**il utilise comme élément de mesure de température (TM) un élément de température qui travaille sur base silicium et qui, en fonction de la température de la couche de blocage du transistor, délivre un signal de sortie proportionnel, en particulier en courant, en tension ou en résistance.

3. Procédé selon la revendication 1, **caractérisé en ce qu'**il utilise une résistance NTC ou une résistance PTC comme élément (TM) de mesure de température.

4. Procédé selon l'une des revendications précédentes, **caractérisé en ce que** l'élément (TM) de mesure de température est fixé sur la puce PMT (PMT).
